# EUROPÄISCHE PATENTANMELDUNG

(11) **EP 0 573 879 A2**
(43) Veröffentlichungstag der Anmeldung: **15.12.1993**
(21) Anmeldenummer: 93108779.5
(22) Anmeldetag: 01.06.1993
(51) Int. Cl.: G21K 4/00, H01J 9/227

(54) **Verfahren zum Erzeugen einer strukturierten Leuchtstoffschicht**

(30) Priorität: 12.06.1992 DE 4219349
(71) Anmelder: SIEMENS AKTIENGESELLSCHAFT, D-80333 München (DE)
(72) Erfinder: Jahnke, Andreas, Dr., W-8000 München 82 (DE); Berthold, Thomas, Dr., W-8000 München 45 (DE)

(57) **Zusammenfassung**

Es wird vorgeschlagen, eine Leuchtstoffschicht durch anisotropes Aufdampfen zu erzeugen und dabei gezielt Strukturverwerfungen oder Gräben in der Leuchtstoffschicht zu induzieren. Über dem Substrat wird dazu eine elastische Schicht mit einem Muster von Rillen versehen, welches einem gewünschten Muster von Strukturlücken in der Leuchtstoffschicht entspricht. Unterschiedliche thermische Ausdehnungskoeffizienten von Leuchtstoff und Substrat führen zu einer verstärkten Kontraktion der Leuchtstoffschicht, wobei diese an den Verwerfungen bricht und vollständig voneinander getrennte Schichtbereiche (Inseln) entstehen. Die Leuchtstoffschicht ist zur Herstellung eines Röntgendetektors mit hoher Ortsauflösung geeignet.

## Beschreibung

Zur Detektion und zum Sichtbarmachen energiereicher Strahlung werden Leuchtstoffe eingesetzt, die extrem kurzwellige elektromagnetische Strahlung in sichtbares Licht umwandeln und so fürs Auge oder einen Photodetektor zugänglich machen. Anwendungen für Leuchtstoffe finden sich daher auf technisch pyhsikalischem Gebiet zur Messung von Strahlung oder insbesondere im medizinischen Bereich bei der Radiographie.

Für medizinische Röntgendetektoren, beispielsweise für die digitale Radiographie, werden Röntgenleuchtschirme mit hoher Ortsauflösung benötigt. Diese müssen Leuchtstoffschichten aufweisen, in denen die laterale Ausbreitung des erzeugten sichtbaren Lichtes unterdrückt ist. Dazu wurden bislang verschiedene Wege verfolgt:

In dünnen Leuchtstoffschichten ist die Ortsauflösung durch die Schichtdicke gegeben. Innerhalb eines Kreises, dessen Radius gleich der Schichtdicke ist, fällt das Streulicht eines Lichtpunktes auf eine Intensität von weniger als 10 Prozent der ursprünglichen Intensität ab. Bei einer Schichtdicke von zum Beispiel 200 µm würde sich damit eine Auflösung von ca. 2,5 lp/mm (Linienpaare pro Millimeter) ergeben.

Die laterale Lichtausbreitung innerhalb der Leuchtstoffschicht kann außerdem durch verstärkte Lichtabsorption des Leuchtstoffmaterials unterdrückt werden. Diese Möglichkeit führt die ebenso wie die vorgenannte zwar zu einer Verbesserung der Ortsauflösung, gleichzeitig jedoch auch zu einer Verminderung der Lichtausbeute und damit zu einer Verminderung der Empfindlichkeit der Leuchtstoffschicht.

Ein dritter Weg nutzt das nadelförmige Wachstum von aufgedampften Alkalihalogenidschichten. Bei Substrattemperaturen zwischen 170 und 250°C können nach einer Bekeimungsphase durchgehend aus Alkalihalogenidnadeln aufgebaute Leuchtstoffschichten erzeugt werden. Einzelne Kristallnadeln wirken als Lichtleiter, so daß das Lumineszenzlicht überwiegend innerhalb der Kristalle geleitet wird, in denen es durch Szintillation entstanden ist. Damit wird eine anisotrope Lichtleitung parallel zur Orientierung der Kristallnadeln gewährleistet. Nachteilig an diesem Verfahren ist jedoch, daß das Kristallwachstum und damit die Struktur der Leuchtstoffschicht nur indirekt durch Beeinflussung der Diffusion eingestellt werden kann. Außerdem ist das Verfahren in extremer Weise von der Oberflächenbeschaffenheit des Substrats abhängig, auf dem die Leuchtstoffschicht aufgedampft wird. Eine Störung des Kristallwachstums führt zu einem Zusammenwachsen einzelner Nadeln, was in der Leuchtstoffschicht zu einem "Übersprechen" von Licht quer zur Nadelorientierung und damit zu einer Verschlechterung der Auflösung der Leuchtstoffschicht führt.

Eine weitere Möglichkeit besteht darin, eine Leuchtstoffschicht auf mechanischem Weg in einzelne Leuchtstoffpunkte (Pixel) aufzutrennen, beispielsweise durch Sägen oder ähnliche Techniken. Damit können jedoch nur breite Spalten zwischen den Pixeln erzeugt werden, die bei einer entsprechend feinen Rasterung zu einem hohen Verlust an aktiven Leuchtstoffmaterial führen und damit ebenfalls zu einer Verringerung der Lichtausbeute.

Aufgabe der vorliegenden Erfindung ist es daher, ein Verfahren zum Erzeugen einer Leuchtstoffschicht anzugeben, welches einfach und gut reproduzierbar durchzuführen ist und das zu einer Leuchtstoffschicht mit hoher Ortsauflösung bei gleichzeitig hoher Lichtausbeute führt.

Diese Aufgabe wird erfindungsgemäß gelöst durch ein Verfahren nach Patentanspruch 1. Weitere Ausgestaltungen der Erfindung sowie ein eine solche Leuchtstoffschicht umfassender Schichtaufbau und eine vorteilhafte Verwendung für den Schichtaufbau sind weiteren Ansprüchen und den Unteransprüchen zu entnehmen.

Die Erfindung nutzt die starke Abhängigkeit des Kristallwachstums von der Oberflächenbeschaffenheit des Substrats. Bislang streng zu vermeidende Oberflächenunebenheiten des Substrats werden nun gezielt ausgenützt, um Stufen in der Leuchtstoffschicht zu erzeugen, die zu einer Strukturierung dieser Schicht führen. Werden die Rillen im Substrat bzw. in der elastischen Schicht ausreichend tief gewählt, so führen die Stufen in der aufwachsenden Leuchtstoffschicht direkt zu Strukturlücken, wobei vollständig voneinander getrennte Inseln in der Leuchtstoffschicht entstehen. Unterstützt wird die Entstehung von Strukturlücken über dem Rillenmuster durch Schrägaufdampfen, wobei ein Abschattungseffekt an den Kanten der Rillen mit der Oberfläche der elastischen Schicht ausgenutzt wird. In den vom Leuchtstoffdampf abgeschatteten Bereichen, das heißt in den Rillen, findet also kein oder nur ein vermindertes Kristallwachstum statt, so daß über den Rillen Strukturlücken verbleiben.

Da die Breite so erzeugter Strukturlücken von der effektiven Breite des Schattens beim Aufdampfen abhängig ist, wird die Strukturlückenbreite insbesondere bestimmt vom Aufdampfwinkel, unter dem Leuchtstoffdampf die Substratoberfläche trifft, von der Tiefe des Grabens und bei ausreichender Tiefe auch von der Breite des Grabens. Da mit steigender Substrattemperatur auch die Diffusion des Leuchtstoffdampfes zunimmt, ist die effektive Breite der erzeugten Strukturlücken auch noch von der Substrattemperatur beim Aufdampfen abhängig, da die Strukturlücken um so mehr zuwachsen, je höher die Temperatur ist und je großer die Schichtdicke der aufwachsenden Schicht wird.

Für die Erfindung ist es jedoch nicht erforderlich, daß sich eine über die gesamte Schichtdicke der Leuchtstoffschicht erstreckende Strukturlücke direkt beim Aufdampfen ergibt. Die auch beim Zusammenwachsen von Inseln verbleibenden Verwerfungen in der Leuchtstoffschicht über dem Rillenmuster werden durch die Erfindung gezielt dazu genutzt, Risse in der Leuchtstoffschicht entsprechend dem Rillenmuster und damit der gewünschten Strukturierung zu erzeugen. Aufgrund unterschiedlicher thermischer Ausdehnungskoeffizienten von Leuchtstoff und Substratmaterial bilden sich beim Abkühlen an den Stufen Risse in der Schicht, die bei entsprechend großem Unterschied in den Ausdehnungskoeffizienten zu ausreichend breiten Strukturlücken und damit zu einer geeigneten Strukturierung der Leuchtstoffschicht führen.

Die elastische Schicht erfüllt im erfindungsgemäßen Verfahren mehrere Funktionen. Zunächst ist sie erforderlich, um die thermischen Spannungen beim Abkühlen innerhalb einer Insel auszugleichen und die Rißbildung infolgedessen gezielt an den Schwachstellen, das heißt an den Stufen in der Schicht über dem Rillenmuster zu induzieren. Desweiteren kann die elastische Schicht mit einer äußerst ebenen Oberfläche erzeugt werden, wodurch eine gleichmäßige Keimbildung auf ihrer Oberfläche und somit ein äußerst regelmäßiges Kristallwachstum ermöglicht wird. Gleichzeitig ist die Haftung der Leuchtstoffschicht auf der elastischen Schicht überraschend hoch, so daß die thermischen Spannungen beim Abkühlen selbst bei großen Differenzen im Ausdehnungskoeffzienten nicht zu einem Abplatzen oder Ablösen der Leuchtstoffschicht von der Oberfläche der elastischen Schicht führen. Außerdem läßt sich das Rillenmuster in der elastischen Schicht, die üblicherweise ein organischer Lack ist, in einfacher Weise herstellen. Wegen des auf glatter Oberfläche äußerst gleichmäßigen Wachstums der Leuchtstoffschicht sind die durch Rillen im Substrat bzw. in der elastischen Schicht induzierten Verwerfungen und Stufen um so stärker ausgeprägt.

Das Rillenmuster in der elastischen Schicht kann durch Einritzen oder Einprägen in eine ganzflächig auf dem Substrat erzeugte elastische Schicht erfolgen. Die Schicht selbst kann in flüssiger Form oder in Lösung zum Beispiel durch Aufschleudern oder Aufsprühen aufgebracht werden und durch Trocknen und/oder Aushärtung (durch Vernetzung oder anderweitige chemische Reaktion) in den gewünschten Zustand überführt werden. Auch ist es möglich, eine vorgefertigte Kunststoffolie auf dem Substrat aufzubringen.

In einer weiteren vorteilhaften Ausgestaltung der Erfindung umfaßt die elastische Schicht eine Photolackschicht, in der sich ein beliebiges Rillenmuster in besonders einfacher Weise durch Belichten und Entwickeln der Photolackschicht ausbilden läßt.

Die Dicke der elastischen Schicht kann von ca. 1 µm bei flüssig aufgebrachten Lacken bis zu ca. 70 µm bei Verwendung vorgefertigter Kunststoffolien betragen. Aufgrund der thermischen Belastung durch das Aufdampfen der Leuchtstoffschicht bei Temperaturen zwischen zum Beispiel 170 und 250°C sind jedoch dünnere Schichten von beispielsweise 2 bis 4 µm bevorzugt, da dickere Schichten bei diesen Temperaturen zum Verfließen neigen, wodurch das Rillenmuster eingeebnet werden könnte.

Die Rillenbreite wird auf einen Wert von ca. 5 bis 30 µm, vorzugsweise auf einen Wert von 9 bis 20 µm eingestellt. Die Feinheit des Rillenmusters bzw. die Durchmesser der Inseln, die durch die über dem Rillenmuster induzierten Strukturlücken begrenzt werden, ist beliebig wählbar, sollte aber zumindest 50 µm betragen. Bei einer Ausführung der Erfindung, bei der die Strukturlücken allein durch unterschiedliche thermische Ausdehnung induziert werden, ist zusätzlich der absolute Wert der unterschiedlichen Ausdehnung bzw. Schrumpfung maßgeblich. Eine gewünschte Strukturlückenbreite von zumindest 1 µm kann bei entsprechend geringerem Unterschied im Ausdehnungskoeffizienten einen größeren Inseldurchmesser erfordern.

Als vorteilhaftes Muster für die Rillen und somit für die Inselstruktur haben sich wabenförmige Strukturen erwiesen. Die so erzielbaren aktiven Flächen einer strukturierten Leuchtstoffschicht betragen mehr als 90 Prozent einer vergleichsweise unstrukturierten Schicht. Die wabenförmige Struktur hat den weiteren Vorteil, daß zwei benachbarte Reihen von Inseln (Pixeln) zueinander versetzt sind, so daß sich eine höhere Auflösung im Vergleich zu einem beispielsweise quadratischen Muster ergibt.

Bei der Auswahl des Musters ist es weiterhin von Vorteil, wenn das Raster des photoempfindlichen Elementes berücksichtigt wird, mit dem die Leuchtstoffschicht zur Herstellung eines Strahlungsdetektors gekoppelt wird. Wenn dessen Rasterung mit dem Rillenmuster übereinstimmt, so können sich störende Interferenzen, zum Beispiel Moiré-Muster ausbilden. Besser ist es, ein feineres Muster als die Rastergröße des photoempfindlichen Elements auszuwählen, wobei die Unterschiede ausreichend groß gewählt sein sollten.

Ein nach dem erfindungsgemäßen Verfahren hergestellter, eine strukturierte Leuchtstoffschicht umfassender Schichtaufbau kann nun mit einem Photodetektor kombiniert werden, wobei ein funktionsfähiger Röntgendetektor entsteht. Um mit einem solchen Röntgendetektor eine Ortsauflösung zu erzielen, muß auch der Photodetektor oder allgemein das photoempfindliche Element eine Ortsauflösung besitzen. Geeignet sind daher zum Beispiel Photodiodenarrays oder auch CCD-Kameras.

Der Zusammenbau des photoempfindlichen Elements mit dem Schichtaufbau erfolgt üblicherweise in der Art, daß die Leuchtstoffschicht direkt über der Oberfläche des photoempfindlichen Elements angeordnet ist. Voraussetzung für das Funktionieren eines solchen Strahlungsdetektors ist die Durchlässigkeit von Substratmaterial und elastischer Schicht für die zu detektierende Strahlung, zum Beispiel für Röntgenlicht. Da diese Bedingung von den meisten Materialien mit ausreichend niedriger Ordnungszahl erfüllt wird, stehen eine ausreichende Anzahl von Materialien zur Auswahl für das Substrat zur Verfügung. Gut geeignet sind zum Beispiel Substrate aus Aluminiumblech, Glas oder Aluminiumoxidkeramik. Doch auch andere Leichtmetalle, Keramiken oder auch Halbleiter sind geeignet.

Wird ein Substratmaterial verwendet, welches gegenüber sichtbarem Licht transparent ist und unter dem Einfluß von kurzwelliger Strahlung auch transparent bleibt, kann das photoempfindliche Element auch auf der Substratseite des Schichtaufbaus angebracht werden. Ein für diesen Zweck gut geeignetes Substratmaterial ist eine Platte aus faseroptischem Material. Dieses besteht aus zueinander parallel ausgerichteten Einzelfasern, wobei die Platten quer zur Faserorientierung geschnitten sind. In solchen Platten findet eine anisotrope Lichtleitung parallel zur Faserorientierung statt, so daß die Ortsauflösung des Lumineszenzlichtes bei dem Weg durch das Substrat nicht verlorengeht.

Im folgenden wird die Erfindung anhand eines Ausführungsbeispiels und der dazugehörigen Figuren näher erläutert.
- Figur 1: zeigt drei Ausführungen von Mustern, nach denen ein Rillenmuster in der elastischen Schicht erzeugt werden kann,
- Figur 2: zeigt eine Vorrichtung zum anisotropen Aufdampfen einer Leuchtstoffschicht auf ein Substrat, während
- Figur 3: einen Schnitt durch eine erfindungsgemäß strukturierte Leuchtstoffschicht zeigt.

### Ausführungsbeispiel

Es soll eine strukturierte Leuchtstoffschicht aus natriumdotiertem Cäsiumiodid CsI : Na auf einem kristallinen Siliziumwafer als Substrat Su aufgebracht werden. Der Wafer Su wird dazu zunächst mit einem Photolack Ph beschichtet, zum Beispiel mit einer 2 µm dicken aufgeschleuderten Schicht des Photolacks AZ 5214 E (Hoechst). Möglich ist es auch, zum Beispiel 25 µm dicke fertige Photolackfolien aufzubringen, zum Beispiel Ozatec ® T 625 oder R 225.

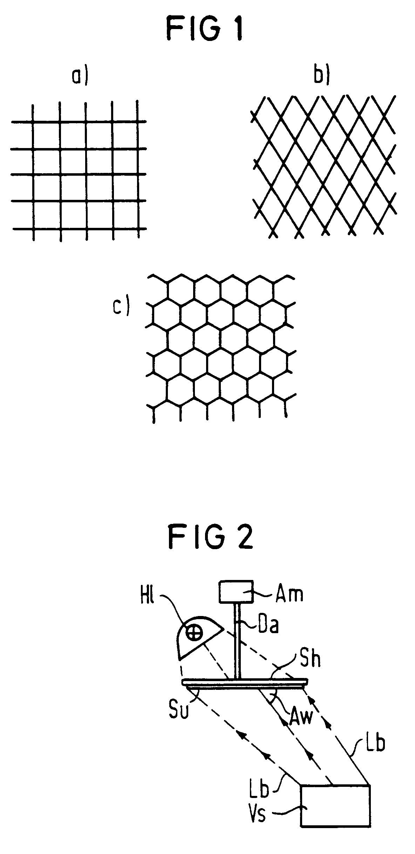

Für die Kontaktbelichtung der Photolackschicht Ph wird eine Photomaske verwendet, die ein gewünschtes Muster, zum Beispiel gemäß Figur 1c aufweist. Je nach Art des verwendeten Photolacks wird bei positivem Photolack das dunkel dargestellte Rillenmuster belichtet oder bei negativem Photolack die hell dargestellten Zwischenräume, die den späteren durch Strukturlücken getrennten Inseln in der Leuchtstoffschicht entsprechen. Nach dem Entwickeln der Photolackschicht Ph verbleiben wabenförmige Schichtbereiche in der Photolackschicht von ca. 100 µm Durchmesser, während die Rillen eine Breite von ca. 10 µm bei einem steilen Flankenwinkel von zum Beispiel 90° gegen das Substrat aufweisen.

Figur 2 zeigt eine Anordnung zur Durchführung des erfindungsgemäßen Verfahrens. Das Substrat Su mit der gemäß dem Wabenmuster strukturierten Photolackschicht Ph wird auf einem Substrathalter Sh so aufgebracht, daß die Photolackschicht Ph nach unten weist. Der Substrathalter Sh selbst ist an einer Drehachse Da befestigt, die über einen Antriebsmotor Am mit einstellbarer Drehgeschwindigkeit angetrieben werden kann.

Als Leuchtstoffschicht soll eine natriumdotierte Cäsiumiodidschicht aufgebracht werden. Das dotierte Alkalihalogenid wird in einem Verdampferschiffchen Vs als Schmelze vorgelegt. Am oberen Rand des Verdampferschiffchens sind zumindest zwei Leitbleche Lb angebracht, mit deren Hilfe ein gerichtetes bzw. ein Schrägaufdampfen ermöglicht wird. Die Leitbleche Lb erlauben beim Verdampfen nur den Austritt solcher Alkalihalogenidmoleküle, deren Geschwindigkeitsvektor einer gewünschten Aufdampfrichtung bzw. einem gewünschten Aufdampfwinkel Aw zum Substrat Su entspricht. Eine Heizlampe Hl sowie ein nicht dargestelltes Thermoelement zur Bestimmung der Substrattemperatur bzw. der Temperatur des Substrathalters Sh vervollständigen die Vorrichtung. Wahlweise kann noch eine Kühlung des Substrathalters Sh vorgesehen sein, um ein schnelleres Aufdampfen zu ermöglichen bzw. bei einer gegebenen Aufdampfgeschwindigkeit eine Überhitzung des Substrates Su zu verhindern.

Das Substrat wird nun auf eine Starttemperatur von zum Beispiel 150°C gebracht. Durch Anlegen von Vakuum an eine Vakuumkammer, in der sich die Vorrichtung befindet, wird das Aufdampfen des Alkalihalogenids auf das Substrat Su bzw. die darauf befindliche Photolackschicht Ph gestartet.

Die gewählte Aufdampftemperatur ist das Ergebnis einer Optimierung und stellt in jedem Fall eine Temperatur dar, bei der die Photolackschicht Ph noch elastisch bzw. plastisch bleibt und noch kein Verfließen des Rillenmusters beginnt. Eine weitere zu beachtende Obergrenze für die Substrattemperatur resultiert aus der mit steigender Temperatur zunehmenden Diffusion des Alkalihalogeniddampfes, die dem anisotropen bzw. schrägen Aufdampfen des Halogenids entgegenwirkt. Eine zu hohe Substrattemperatur wirkt den Abschattungseffekten des Rillenmusters entgegen und vermindert die Ausbildung von Stufen und Rissen in der Alkalihalogenidschicht. Um jedoch eine möglichst hohe Differenz in der thermischen Ausdehnung zwischen Substrat Su und aufwachsender Kristallschicht zu erzielen, ist eine möglichst hohe Substrattemperatur bzw. ein möglichst hohes Temperaturintervall zwischen Normaltemperatur und Aufdampftemperatur gewünscht.

Während des Aufdampfens wird der Substrathalter Sh mit dem Antriebsmotor Am in einer Frequenz von ca. 3 bis 12 Umdrehungen pro Minute um die Achse Da gedreht. Bei einer Aufdampfgeschwindigkeit von weniger als 5 µm pro Minute wächst so eine gleichmäßige Cäsiumiodidschicht auf dem Substrat Su bzw. auf der elastischen Schicht Ph auf.

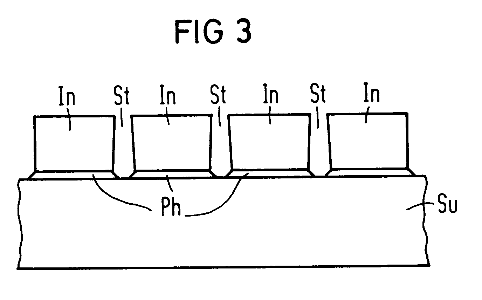

Figur 3 zeigt einen schematischen Querschnitt durch das Substrat und die darauf erzeugten Schichten. Beim schräg Aufdampfen auf das Substrat Su kommt es zu einer Abschattung in den Rillen der Photolackschicht Ph, so in deren Bereich sich keine Cäsiumiodidkristalle bilden können. Auf der Photolackschicht Ph selbst wächst die Cäsiumiodidschicht in Form von zueinander parallelen regelmäßigen Nadeln. Die ursprünglich durch die Rillen in der Photolackschicht Ph bedingte Abschattung setzt sich während des Schichtwachstums fort, so daß auf dem Substrat durch Strukturlücken St vollständig voneinander getrennte Inseln In in der Cäsiumiodidschicht entstehen. Bei einer Schichtdicke der Cäsiumiodidschicht von ca. 400 bis 500 µm wird der Aufdampfvorgang beendet und das Substrat langsam abgekühlt. Das Cäsiumiodid besitzt einen deutlich größeren thermischen Ausdehnungskoeffizienten als das Substratmaterial (hier Silizium), so daß es beim Abkühlen zu einer Verbreiterung der Strukturlücken St kommt. Die Inseln In überstehen die thermische Kontraktion beim Abkühlen ohne Bruch, da sich auftretende Spannungen über die elastische Photolackschicht Ph abbauen.

Mit diesem Mechanismus ist es auch möglich, die Strukturlücken St in der Alkalihalogenidschicht erst eim Abkühlen auszubilden, da diese durch die thermische Kontraktion ausschließlich über den Strukturverwerfungen, also über dem Rillenmuster reißt. Solche Verwerfungen können entstehen, wenn ursprünglich ausgebildete Strukturlücken mit zunehmender Schichtdicke der Cäsiumiodidschicht zuwachsen. Dies kann der Fall sein, wenn der Aufdampfwinkel Aw nicht ausreichend spitz ist, wenn die Diffusion während des Aufdampfens aufgrund zu hoher Temperatur zu groß ist, oder wenn Breite und/oder Tiefe der Rillen nicht dazu geeignet sind, eine ausreichende Abschattung gegenüber dem aufgedampften Alkalihalogenid zu erzeugen.

In der folgenden Tabelle werden für zwei Leuchtstoffe (Cäsiumiodid, Natriumiodid) und für verschiedene übliche Substratmaterialien die relativen Ausdehnungskoffizienten angegeben.

| Leuchtstoff | relativer Ausdehungskoeffizient 1/°C | Substrat | relativer Ausdehnungskoeffizient 1/°C |
|---|---|---|---|
| CsI | 49 . 10⁻⁶ | Al | 25 . 10⁻⁶ |
| NaI | 45 . 10⁻⁶ | Al₂O₃ | 6 . 10⁻⁶ |
| | | Si | 2 . 10⁻⁶ |
| | | SiO₂- | 1 . 10⁻⁶ |
| | | Glas | |

Für alle gängigen Substratmaterialien werden also deutlich geringere Ausdehnungskoeffizienten gemessen als für die Leuchtstoffschichten, so daß für die angegebenen Materialien alle Kombinationen Substrat/Leuchtstoff für die Erfindung geeignet sind. Die Breite der erfindungsgemäß ausgebildeten Strukturlücken bei ursprünglich zugewachsener Leuchtstoffschicht sind dann nur vom Unterschied im Ausdehnungskoeffizienten und vom Abstand der Rillen zueinander bzw. dem Durchmesser der Inselbereiche In abhängig. Die in verschiedenen Versuchen gemessenen Breiten der Strukturlücken bei vorgegebenen Inseldurchmessern stimmen weitgehend mit den theoretisch vorberechneten Werten überein. Im vorbeschriebenen Ausführungsbeispiel werden so bei einem Inseldurchmesser von 200 µm auf einem Temperaturintervall von 175° (Substrattemperatur minus Raumtemperatur) eine Grabenbreite von ca. 1,6 µm errechnet und auch gemessen.

Eine zur Unterdrückung der lateralen Lichtausbreitung innerhalb einer Leuchtstoffschicht ausreichende Breite der Strukturlücken liegt im Bereich der Wellenlänge des Lumineszenzlichtes. In der Praxis werden die Bedingungen bzw. die Geometrien jedoch so gewählt, daß Strukturlücken von 1 bis 2 µm Breite entstehen, die die laterale Lichtausbreitung in gewünschter Weise verhindern.

Ein fertiger Röntgendetektor entsteht durch Kopplung des so erzeugten Schichtaufbaus mit den voneinander getrennten Leuchtstoffinseln In mit einem Photodiodenarray oder einer CCD-Kamera. Von Vorteil ist es dabei, wenn die Pixelgröße des lichtempfindlichen Elements nicht mit der Pixelgröße bzw. mit dem Inseldurchmesser der Leuchtstoffschicht übereinstimmt. Bei einem Pixeldurchmesser von 50 µm für eine CCD-Kamera und einem Inseldurchmesser von 100 µm bei einer zum Beispiel quadratisch strukturierten Leuchtstoffschicht kommen daher im fertigen Röntgendetektor vier Pixel der CCD-Kamera unter einer Leuchtstoffinsel zu liegen. Dadurch werden Moiré-Muster unterdrückt. Der Röntgendetektor besitzt eine Auflösung, die dem Durchmesser der Inseln In in der Leuchtstoffschicht entspricht.

In einer Weiterbildung der Erfindung können die nach dem Aufdampfen über dem Rillenmuster entstandenen Strukturlücken mit einem hochreflektierenden Material zum Beispiel in Form einer Paste verfüllt werden. Damit wird eine noch stärkere optische Trennung der Pixel erreicht, was zur noch besseren Ortsauflösung der Röntgenleuchtschirme führt. Allerdings ist dies nur möglich, wenn die Breite der Strukturlücken für eine derartige Befüllung mit weiterem Material ausreichend groß ist.

## Patentansprüche

1. Verfahren zum Erzeugen einer strukturierten Leuchtstoffschicht, bei dem
- ein Substrat (Su) mit einer elastischen Schicht (Ph) versehen wird,
- zumindest in der elastischen Schicht ein Muster von Rillen erzeugt wird, welches einem gewünschten Muster von Strukturlücken in der zu erzeugenden Leuchtstoffschicht entspricht,
- eine Leuchtstoffschicht bei erhöhter Substrattemperatur auf die elastische Schicht (Ph) mit dem Rillenmuster anisotrop aufgedampft wird, und
- das Substrat (Su) schließlich abgekühlt wird.

2. Verfahren nach Anspruch 1, bei dem ein Substrat (Su) verwendet wird, das einen kleineren thermischen Ausdehnungskoeffizienten besitzt als der Leuchtstoff.

3. Verfahren nach Anspruch 1 oder 2, bei dem unter einem spitzen Winkel (AW) auf das Substrat (Su) aufgedampft wird.

4. Verfahren nach einem der Ansprüche 1 bis 3, bei dem eine Photolackschicht (Ph) als elastische Schicht auf dem Substrat (Su) aufgebracht wird.

5. Verfahren nach einem der Ansprüche 1 bis 3, bei dem als elastische Schicht eine organische Lackschicht aufgebracht wird und das Rillenmuster in die Lackschicht eingeritzt oder eingeprägt wird.

6. Verfahren nach einem der Ansprüche 1 bis 5, bei dem ein Rillenmuster mit einer Rillenbreite von 5 bis 30 µm, vorzugsweise von 9 bis 20 µm erzeugt wird.

7. Schichtaufbau mit einer strukturierten Schicht aus einem aufdampfbaren Leuchtstoff, welcher folgende Schichtreihenfolge aufweist:
- ein Substrat (Su),
- eine organische Schicht (Ph),
- eine Leuchtstoffschicht, die durch ein Grabenmuster (St) vollständig voneinander getrennte Schichtbereiche (Inseln) (In) aufweist, wobei
die Dicke der Leuchtstoffschicht 200 bis 600 µm und die Grabenbreite des Musters 1 bis 20 µm beträgt.

8. Schichtaufbau nach Anspruch 7, bei dem die Durchmesser der Inseln (In) im Bereich von 50 bis 500 µm liegen.

9. Schichtaufbau nach Anspruch 7 oder 8, welcher ein dotiertes Alkalihalogenid oder Zinksulfid als Leuchtstoff umfaßt.

10. Schichtaufbau nach einem der Ansprüche 7 bis 9, welcher mit einem photoempfindlichen Element gekoppelt ist.

11. Schichtaufbau nach Anspruch 10, bei dem das Substrat (Su) eine Platte aus faseroptischem Material umfaßt.

12. Schichtaufbau nach Anspruch 10 oder 11, welcher mit einer CCD-Kamera als photoempfindlichem Element gekoppelt ist.

13. Verwendung des Schichtaufbaus nach Anspruch 10 für die digitale Radiographie.
